(19) Europäisches Patentamt / European Patent Office / Office européen des brevets

(11) **EP 1 797 603 B1**

(12) **EUROPÄISCHE PATENTSCHRIFT**

(45) Veröffentlichungstag und Bekanntmachung des Hinweises auf die Patenterteilung:
**05.08.2009 Patentblatt 2009/32**

(51) Int Cl.:
*H01L 41/113* (2006.01)   *G01L 1/16* (2006.01)
*G01L 9/08* (2006.01)   *G01P 15/09* (2006.01)

(21) Anmeldenummer: **05790304.9**

(86) Internationale Anmeldenummer:
**PCT/AT2005/000400**

(22) Anmeldetag: **07.10.2005**

(87) Internationale Veröffentlichungsnummer:
**WO 2006/037145 (13.04.2006 Gazette 2006/15)**

(54) **SENSORELEMENT MIT ZUMINDEST EINEM MESSELEMENT, WELCHES PIEZOELEKTRISCHE UND PYROELEKTRISCHE EIGENSCHAFTEN AUFWEIST**

SENSOR ELEMENT HAVING AT LEAST ONE MEASUREMENT ELEMENT WITH PIEZOELECTRIC AND PYROELECTRIC PROPERTIES

ELEMENT CAPTEUR COMPRENANT AU MOINS UN ELEMENT DE MESURE A PROPRIETES PIEZOELECTRIQUES ET PYROELECTRIQUES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **07.10.2004 AT 16772004**

(43) Veröffentlichungstag der Anmeldung:
**20.06.2007 Patentblatt 2007/25**

(73) Patentinhaber: **Piezocryst Advanced Sensorics GmbH**
**8020 Graz (AT)**

(72) Erfinder:
• **GLASER, Josef**
**A-8047 GRAZ (AT)**
• **KRÖGER, Dietmar**
**A-8010 Graz (AT)**
• **LEUPRECHT, Gernot**
**A-8061 St. Radegund-Rinnegg (AT)**
• **REITER, Christian**
**A-8020 Graz (AT)**

(74) Vertreter: **Babeluk, Michael**
**Patentanwalt**
**Mariahilfer Gürtel 39/17**
**1150 Wien (AT)**

(56) Entgegenhaltungen:
EP-A- 0 055 345    GB-A- 2 224 598
US-A- 3 060 748    US-A- 3 877 308
US-A- 4 792 682    US-A- 4 841 494
US-A- 5 677 487

EP 1 797 603 B1

**Beschreibung**

Die Erfindung betrifft ein Sensorelement mit zumindest einem Messelement, welches piezoelektrische und pyroelektrische Eigenschaften aufweist und mit Messelektroden ausgestattet ist, wobei auf das zumindest eine Messelement gleichzeitig eine Messgröße und eine Störgröße einwirkt und das von den Messelektroden abgeleitete Messsignal ein Störsignal aufweist und zumindest einem Kompensationselement, welches piezoelektrische und/oder pyroelektrische Eigenschaften aufweist und mit Kompensationselektroden versehen ist, wobei auf das Kompensationselement nur die Störgröße einwirkt, sodass vom Kompensationselement ein Korrektursignal ableitbar ist, welches zur Kompensation des Störsignals im Messsignal dient.

Piezoelektrische Sensorelemente zur Messung mechanischer Größen, beispielsweise Druck, Kraft oder Beschleunigung haben ein breites Anwendungsspektrum gefunden, wobei bei derartigen Sensoren insbesondere der Grad der möglichen Miniaturisierung und die praktisch weglose Messung der genannten mechanischen Größen als Vorteil hervorzuheben ist. Für unterschiedliche Messbereiche kommen unterschiedliche piezoelektrische Materialien zum Einsatz, welche allerdings zum Teil sehr teuer (beispielsweise Galliumorthophosphat im Hochtemperaturbereich) und/oder nicht ausreichend verfügbar sind.

Viele piezoelektrische Materialien (wie beispielsweise Turmalin) sind aufgrund ihrer großen Temperaturbeständigkeit und der hohen piezoelektrischen Empfindlichkeit sehr gut für Sensoranordnungen geeignet, zeigen jedoch neben den piezoelektrischen Eigenschaften auch eine Pyroelektrizität, welche bei vielen Anwendungen störend wirkt. So sind beispielsweise Druckmessungen in Bereichen mit einer sich ändernden Temperaturbeaufschlagung (beispielsweise in Brennräumen von Brennkraftmaschinen) mit piezoelektrischen Materialien, welche gleichzeitig pyroelektrische Eigenschaften aufweisen mit einem Störsignal behaftet, welches vom eigentlichen Messsignal nicht unterschieden werden kann. ,

Die Ursache des Störsignals beispielsweise bei einem Drucksensor liegt darin, dass am piezoelektrischen Element nicht nur durch die Druckbeaufschlagung Ladung entsteht, sondern auch durch die Temperaturänderungen, so dass sich das nach der Ladungsableitung ergebende elektrische Signal aus einem von der Druckänderung und einem von der Temperaturänderung abhängigen Signalanteil zusammensetzt.

In diesem Zusammenhang ist aus der EP 0 055 345 A1 ein Kraftsignalgeber zur Erfassung von dynamischen und/oder quasistatischen Kräften bekannt geworden, bei welchem in einem abgeschirmten Gehäuse zwei piezokeramische Plättchen angeordnet sind, von denen eines mit einem Koppelement zur Krafteinleitung verbunden ist und das andere als Kompensationselement für Störsignale nichtmechanischen Ursprungs dient. Der Kraftaufnehmer und das Kompensationselement weisen die gleiche Geometrie auf, mit dem Unterschied, dass eine Krafteinleitung nur zum Kraftaufnehmer erfolgen kann. Das Kompensationselement weist einen Luftspalt zur krafteinleitenden Struktur auf, so dass hier keine Krafteinleitung möglich ist und nur Signale nichtmechanischen Ursprungs erfasst werden können.

Ein wesentlicher Nachteil eines Kraftsignalgebers gemäß EP 0 055 345 A1 liegt darin, dass sich bei unterschiedlichen Temperaturen $T_1$ und $T_2$ in den krafteinleitenden Strukturen, bzw. bei einer sich rasch ändernden Temperatur $T_1$ oder $T_2$ unterschiedliche Temperaturgradienten, bzw. Temperaturfelder im Messelement und im Kompensationselement ausbilden und so nur eine unzureichende Kompensation erzielt werden kann.

Bei einer Messvorrichtung gemäß Fig. 3 der EP 0 055 345 A1 würde sich bei unterschiedlichen Temperaturen $T_1$ im Sockel, bzw. $T_2$ in der Gehäusehülle im Messelement ein Temperaturgradient in Abhängigkeit der Temperaturen $T_1$ und $T_2$ einstellen, während das Kompensationselement im Wesentlichen die Temperatur $T_1$ des Sockels annehmen würde. Verstärkt würde dieser Effekt noch bei sich zeitlich ändernden Temperaturen, beispielsweise bei der Druckmessung in Brennräumen von Brennkraftmaschinen.

Aus der US 3,877,308 ist ein temperaturkompensiertes, pyroelektrisches Sensorelement bekannt, das auf einem Basiselement aus pyroelektrischem Material einen Messbereich mit einem ersten Elektrodenpaar, sowie einen Kompensationsbereich mit einem zweiten Elektrodenpaar aufweist. Die Elektroden der beiden Elektrodenpaare sind kreuzweise miteinander verschaltet, so dass eine durch Heizen oder Kühlen im Messbereich herrschende Temperatur im Hinblick auf eine schwankende Umgebungstemperatur kompensiert werden kann.

Aufgabe der vorliegenden Erfindung ist es, ein Sensorelement mit einem Messelement, welches sowohl piezoelektrische als auch pyroelektrische Eigenschaften aufweist, derart zu verbessern, dass auf möglichst einfache Weise ein störungsfreies Messsignal gewonnen werden kann.

Diese Aufgabe wird erfindungsgemäß dadurch gelöst, dass das Kompensationselement mit einer ersten und einer zweiten Messelementauflage des Messelementes oder mit dem Messelement entlang dessen Längserstreckung zwischen den Messelementauflagen in thermischem Kontakt steht, sodass sich im Messelement und im Kompensationselement im Wesentlichen dasselbe Temperaturfeld einstellt, wobei das Kompensationselement zu zumindest einer der Messelementauflagen von der Einleitung mechanischer Größen entkoppelt ist. Das Kompensationselement weist in seiner Längserstreckung zwischen den Messelementauflagen im Wesentlichen die gleiche Baulänge wie das Messelement auf, sodass der Temperaturverlauf längs dieser Strecke aufintegriert wird. Das führt zu einer optimalen Kompensation der temperaturbedingten Signalanteile, selbst bei einer sich zeitlich oder örtlich ändernden Temperaturbelastung.

Zur Entkopplung mechanischer Größen weist das Kompensationselement beispielsweise zu zumindest einer Messelementauflage ein mechanische Kräfte absorbierendes, gut wärmeleitendes Element auf.

Besonders vorteilhaft ist es, wenn die Fläche der Kompensationselektroden im Hinblick auf die Fläche der Messelektroden im Sinne einer Kompensierung der Störgröße dimensioniert sind und eine elektrisch leitende Verbindung aufweisen. Dadurch erfolgt in vorteilhafter Weise eine innere Kompensation der Störgröße direkt am Messelement ohne elektronische Signalverarbeitung.

Wenn beispielsweise die Kraft F die Messgröße und die mittlere Temperatur T die Störgröße ist, setzt sich das Gesamtsignal S aus einem Signalanteil $S_{ME}$ des Messelementes und einem Signalanteil $S_{KE}$ des Kompensationselementes zusammen, welche Signalanteile von folgenden Größen abhängen:

$$S_{ME} = F \times E_{piezo} \times A_{ME} + T \times E_{pyro} \times A_{ME} \qquad (1)$$

$$S_{KE} = T \times E_{pyro}^{*} \times A_{KE} \qquad (2)$$

mit $E_{piezo}$ piezoelektrische Empfindlichkeit des Messelementes
$E_{pyro}$ pyroelektrische Empfindlichkeit des Messelementes
$E_{pyro}^{*}$ pyroelektrische Empfindlichkeit des Kompensationselementes
$A_{ME}$ Elektrodenfläche der Messelektroden
$A_{KE}$ Elektrodenfläche der Kompensationselektroden
Daraus folgt - wenn der Signalanteil $S_{KE}$ von $S_{ME}$ abgezogen wird:

$$S = S_{ME} - S_{KE} = F \times E_{piezo} \times A_{ME} + T \times E_{pyro} \times A_{ME} - T \times E_{pyro}^{*} \times A_{KE}$$

sowie

$$S = F \times E_{piezo} \times A_{ME} + T \times (E_{pyro} \times A_{ME} - E_{pyro}^{*} \times A_{KE}) \qquad (3)$$

Der Klammerausdruck wird dann Null, d.h. eine vollständige Kompensation des pyroelektrischen Effektes wird erreicht, wenn die beiden Produkte aus pyroelektrischer Empfindlichkeit und Elektrodenfläche beim Messelement und beim Kompensationselement gleich groß sind. Beim Einsatz unterschiedlicher Materialien für das Messelement und das Kompensationselement kann somit die Elektrodenfläche des Kompensationselementes an die Elektrodenfläche des Messelementes entsprechend angepasst werden, um eine vollständige Kompensation zu erreichen.

Von besonderem Vorteil ist es dabei, wenn das zumindest eine Messelement und das zumindest eine Kompensationselement aus dem selben Material bestehen. $E_{pyro}$ und $E_{pyro}^{*}$ sind dann gleich groß, sodass auch gleiche Elektrodenflächen $A_{ME}$ und $A_{KE}$ gewählt werden können.

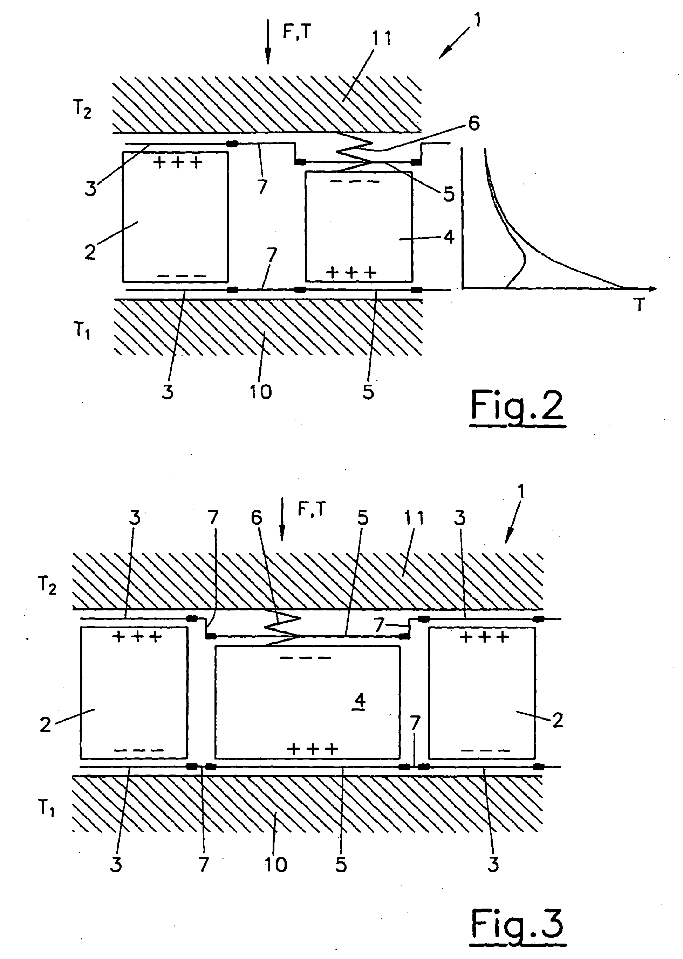

Wenn man beispielsweise als Messgröße eine veränderliche mechanische Größe, z.B. Kraft, Druck, Spannung oder Beschleunigung misst und als Störgröße eine veränderliche Temperatur am Messort berücksichtigen muss, so ist darauf zu achten, dass sich das Messelement und das Kompensationselement im selben Temperaturfeld befinden, das heißt, dass auf die beiden Elemente derselbe Temperaturverlauf einwirkt. Weiters muss in der Messanordnung dafür gesorgt werden, dass auf das Kompensationselement nur die Störgröße, beispielsweise die Temperatur, einwirkt. Durch eine gegensinnige Zusammenschaltung der Messelektroden mit den Kompensationselektroden (siehe z.B. Fig. 2) kompensieren sich die aus der Temperaturbelastung herrührenden Ladungsanteile, so dass das Messsignal proportional zu den durch Druckbeaufschlagung erzeugten Ladungsanteilen ist.

Gemäß einer Variante der Erfindung ist es auch möglich, die Kompensationselektroden unter Zwischenschaltung eines elektronischen Verstärkergliedes mit den Messelektroden zu verbinden. Es erfolgt somit keine innere Kompensation, sondern eine Kompensation durch eine entsprechende Verstärkung des Signalanteils $S_{KE}$.

Die Elektrodenfläche des Kompensationselementes oder der Verstärkungsfaktor eines Verstärkergliedes kann auch derart gewählt werden, dass neben dem pyroelektrischen Effekt auch andere Störeffekte, beispielsweise temperaturproportionale Fehlsignale aus Verspannungen zwischen Messelement und Messelementauflage, kompensiert werden.

Wenn gemäß einer anderen Ausführungsvariante der Erfindung die Messgröße eine veränderliche Temperatur, und die Störgröße eine veränderliche mechanische Größe, beispielsweise Kraft, Druck, Spannung oder Beschleunigung ist, muss darauf geachtet werden, dass das Kompensationselement nur von der mechanischen Größe, nicht aber von der Temperatur beaufschlagt wird. Das Ergebnis ist ein druckkompensierter Temperatursensor, welcher sich dadurch auszeichnet, dass das Messelement und das Kompensationselement in einer seriellen Anordnung im selben Kraftfeld zwischen einer ersten und einer zweiten Messelementauflage angeordnet sind, wobei zwischen dem Messelement und dem Kompensationselement ein elektrisch und thermisch isolierendes Distanzelement angeordnet ist.

In Analogie zu den Gleichungen 1 bis 3 ergibt sich dann ein Gesamtsignal S mit

$$S = F \times E_{pyro} \times A_{ME} + T \times (E_{piezo} \times A_{ME} - E_{piezo}^* \times A_{KE}) \qquad (4)$$

mit: $E_{pyro}$ pyroelektrische Empfindlichkeit des Messelementes
$E_{piezo}$ piezoelektrische Empfindlichkeit des Messelementes und
$E_{piezo}^*$ piezoelektrische Empfindlichkeit des Kompensationselementes

Eine vollständige Kompensation des piezoelektrischen Effektes wird dann erreicht, wenn die beiden Produkte aus piezoelektrischer Empfindlichkeit und Elektrodenfläche beim Messelement und beim Kompensationselement gleich groß sind und der Klammerausdruck Null ist.

Gemäß einer weiteren erfindungsgemäßen Ausführungsvariante kann das Messelement und das Kompensationselement in zwei Teilbereichen eines einzelnen piezoelektrischen Elementes realisiert sein, wobei ein erster Teilbereich die Messelektroden und ein zweiter Teilbereich die Kompensationselektroden trägt.

Die Erfindung wird im Folgenden anhand von schematischen Zeichnungen näher erläutert. Es zeigen:

Fig. 1a   bis Fig. 1c piezoelektrische Elemente und unterschiedliche piezoelektrischen Effekte, welche für das erfindungsgemäße Sensorelement einsetzbar sind;

Fig. 2   eine erste Ausführungsvariante eines erfindungsgemäßen Sensorelementes zur Messung einer mechanischen Größe in einer Schnittdarstellung mit separatem Messelement und Kompensationselement;

Fig. 3   eine Ausführungsvariante des Sensorelements gemäß Fig. 2;

Fig. 4   und Fig. 5 Ausführungsvarianten des Sensorelementes, bei welchen das Messelement und/oder das Kompensationselement aus mehreren Einzelelementen besteht;

Fig. 6   eine Ausführungsvariante des Sensorelementes mit ausgelagertem Kompensationselement;

Fig. 7   eine Ausführungsvariante des Sensorelementes mit einstückiger Ausführung des Messelementes und des Kompensationselementes;

Fig. 8   eine Schnittdarstellung, sowie die Fig. 8a und Fig. 8b Schrägansichten einer Ausführungsvariante des Sensorelementes gemäß Fig. 7 in einer kreissymmetrischen Bauform;

Fig. 9,   Fig. 9a und Fig. 9b bzw. die Fig. 10, Fig. 10a und Fig. 10b Ausführungsvarianten des Sensorelementes gemäß Fig. 8; sowie

Fig. 11   eine Ausführungsvariante des Sensorelementes nach Fig. 2 mit elektronischer Verstärkung des Störsignals.

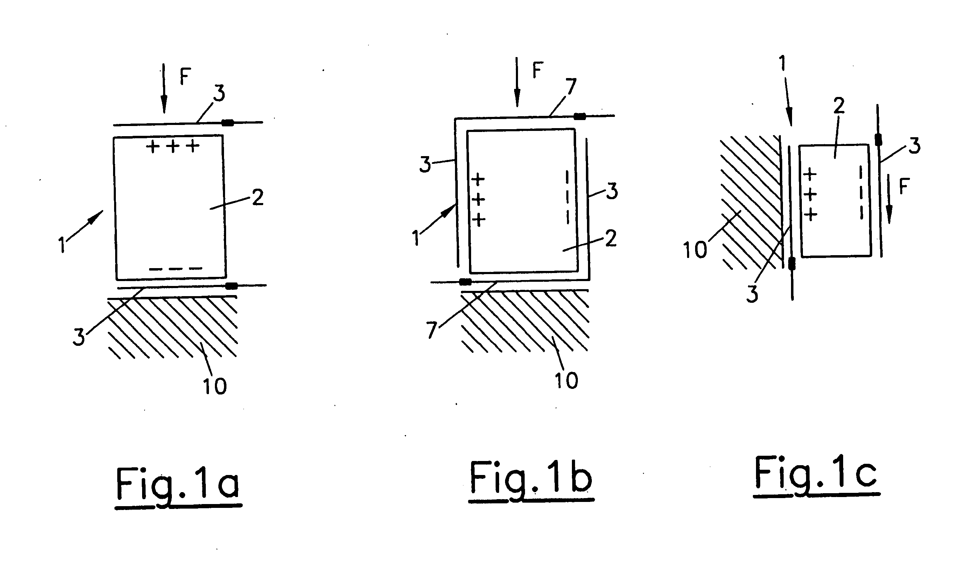

In den Fig. 1a, Fig. 1b und Fig. 1c ist jeweils ein piezoelektrisches Messelement 2 eines Sensorelementes 1 dargestellt, wobei die für die vorliegende Erfindung nutzbaren piezoelektrischen Effekte schematisch dargestellt sind.

In Fig. 1a wirkt auf das piezoelektrische Messelement 2 eine Kraft F, wobei durch die mechanische Beanspruchung die positiven und negativen Gitterbausteine des Kristalls so verschoben werden, dass eine elektrische Polarisation entsteht, die sich im Auftreten von Ladungen (+ bzw. -) an gegenüberliegenden Oberflächen äußert. Die Ladungen werden durch Messelektroden 3 abgeführt, wobei die so gewonnene Spannung der auf das Messelement 2 wirkenden Kraft F proportional ist. In Fig. 1a wird der longitudinale Piezoeffekt dargestellt.

Ähnliche Effekte ergeben sich bei einer Kraftbeaufschlagung gemäß Fig. 1b (transversaler Piezoeffekt) und Fig. 1c (Scherspannung), wobei die Messelementauflage jeweils mit 10 bezeichnet ist.

Zur besseren Darstellung sind in den schematischen Abbildungen die Messelektroden 3 (beispielsweise eine elektrisch leitende Folie bzw. eine elektrisch leitende Beschichtung) mit einem in der Praxis natürlich nicht vorhandenen Abstand zum Messelement 2 dargestellt, gleiches gilt für den Abstand zwischen den Messelektroden 3 und der Messelementauflage 10.

In den folgenden Beispielen von erfindungsgemäßen Ausführungsvarianten wird großteils der longitudinale Piezoeffekt gemäß Fig. 1a ausgenutzt, in gleicher Weise gilt die Erfindung auch für die Ausnützung der in den Fig. 1b und Fig. 1c dargestellten anderen piezoelektrischen Effekte.

Bei der ersten erfindungsgemäßen Ausführungsvariante gemäß Fig. 2 weist das Sensorelement 1 ein Messelement 2 mit an gegenüberliegenden Flächen angeordneten Messelektroden 3 auf, wobei im Hinblick auf die Kraftbeaufschlagung F und die Temperaturbeaufschlagung T in einer antiparallelen Anordnung ein Kompensationselement 4 vorgesehen ist, welches auf gegenüberliegenden Flächen mit Kompensationselektroden 5 ausgestattet ist. Beide Elemente sind im selben Temperaturfeld zwischen einer ersten 10 und einer zweiten Messelementauflage 11 parallel bzw. in Bezug auf den sich ausbildenden Dipol anti-parallel angeordnet, so dass sich auch bei wechselnden Temperaturen $T_1$ und $T_2$ für beide Elemente der selbe Temperaturgradient einstellt. Im dargestellten Beispiel ist das Kompensationselement 4 von der Einleitung mechanischer Größen entkoppelt und weist zur Messelementauflage 11 ein mechanische Kräfte absorbierendes, gut wärmeleitendes Element 6 auf (im folgenden auch Federelement genannt), so dass auf das Kompensationselement 4 nur die Störgröße, nämlich die Temperatur T einwirkt, da die mechanische Größe F aufgrund des Federelementes 6 praktisch nicht in das Kompensationselement 4 eingeleitet werden kann.

Das Federelement 6 ist zur besseren Darstellung in den schematischen Abbildungen überhöht dargestellt. In der Praxis kann das Federelement z. B. als gewelltes Plättchen aus einem elastischen Material (beispielsweise Stahl) mit guten Wärmeleiteigenschaften ausgeführt sein, sodass das Messelement 2 und das Kompensationselement 4 im Wesentlichen die selbe Baulänge zwischen den beiden Auflagen 10 und 11 aufweisen. Die für beide Elemente 2 und 4 identen Grenz-Temperaturverläufe über einen Heiz-Kühl-Zyklus bei einer zyklischen Temperaturschwankung von $T_1$ in der Messelementauflage 10 sind im Diagramm seitlich vom Sensorelement 1 dargestellt. Alle Temperaturverläufe über einen Zyklus liegen innerhalb der beiden Grenzkurven.

Das Messelement 2 und das Kompensationselement 4 sind gemäß Fig. 2 anti-parallel angeordnet, so dass die entsprechenden Elektroden 3 und 5 über Verbindungsleitungen 7 direkt elektrisch leitend miteinander verbunden werden können.

Für das Messelement 2 und das Kompensationselement 4 können unterschiedliche Materialien mit piezoelektrischen und pyroelektrischen Eigenschaften verwendet werden. Die Fläche der Kompensationselektroden 5 muss dabei auf die Fläche der Messelektroden 3 derart angepasst werden, dass eine Kompensierung der Störgröße erzielt werden kann (siehe Gleichung 3).

Besonders vorteilhaft ist es, wenn das Messelement 2 und das Kompensationselement 4 aus dem selben piezoelektrischen und pyroelektrischen Material bestehen und zudem gleiche Wirkquerschnitte aufweisen. In diesem Fall können die Elektrodenflächen für die Messelektroden 3 und die Kompensationselektroden 5 gleich groß sein. Das mechanische Kräfte absorbierende, gut wärmeleitende Element 6 kann auch auf der anderen Seite zwischen dem Kompensationselement 4 und der Messelementauflage 10 bzw. auch auf beiden Seiten angeordnet sein.

Die in Fig. 3 dargestellte Ausführungsvariante gleicht jener gemäß Fig. 2 mit dem Unterschied, dass hier eine symmetrische Krafteinleitung möglich ist und die wirksamen Querschnitte der Mess- und Kompensationselemente 2, 4 entsprechend angepasst sind.

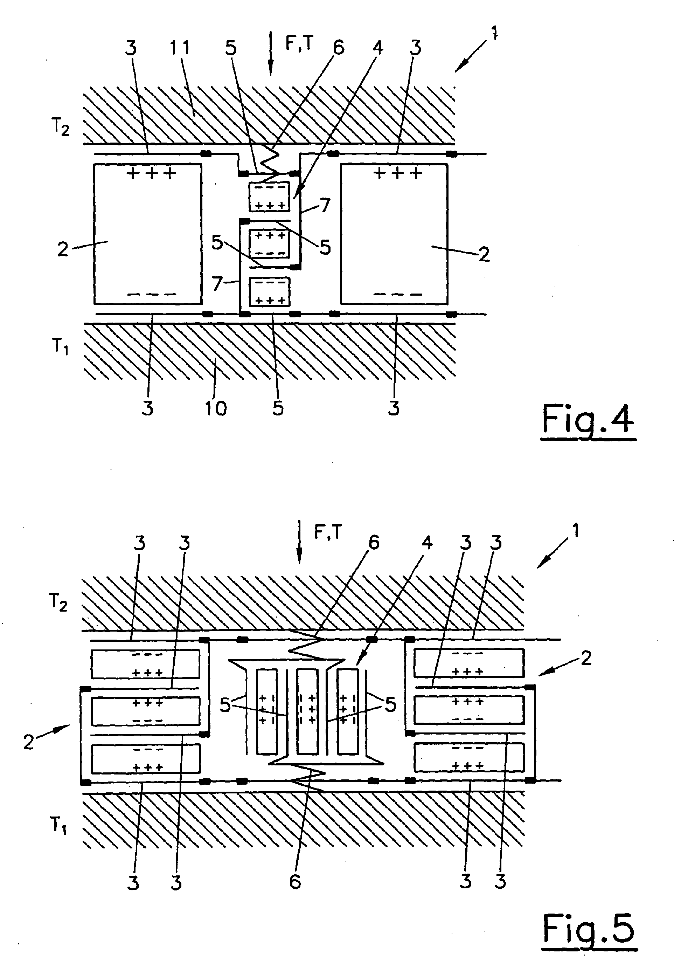

Bei den in den Fig. 4 und Fig. 5 dargestellten Ausführungsvarianten sind das Messelement 2 (siehe Fig. 5) und/oder das Kompensationselement 4 (siehe Fig. 4 und Fig. 5) unter Nutzung des longitudinalen oder des transversalen Piezoeffektes aus mehreren Einzelelementen entgegengesetzter Polarität zusammengesetzt, wobei die Einzelelemente des Kompensationselementes 4 in Fig. 5 um 90° gedreht angeordnet sind. Platzsparend kann somit die für eine Kompensation erforderliche Elektrodenfläche der Kompensationselektroden 5 durch mehrere dünne Einzelelemente realisiert werden.

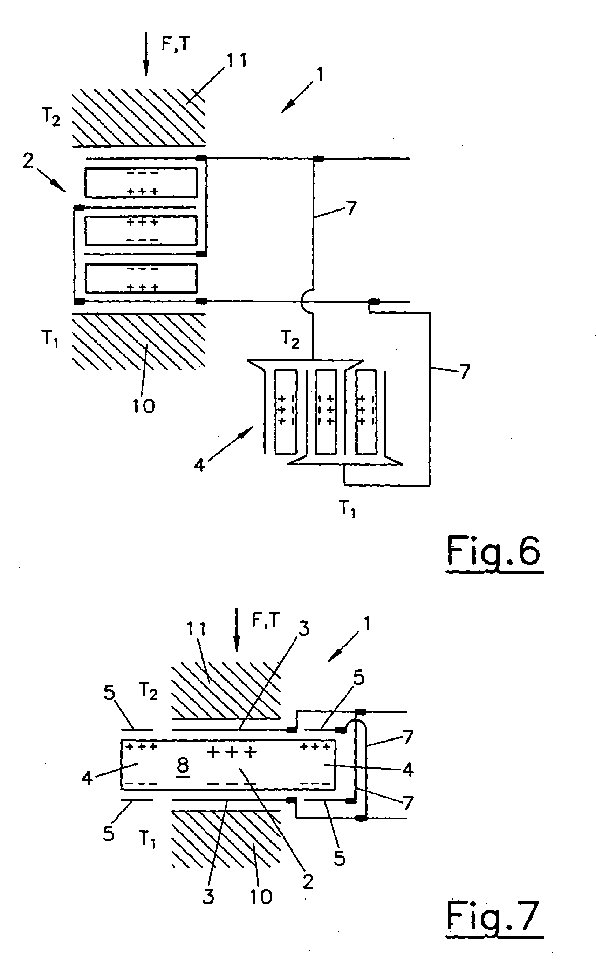

Wie in der Ausführungsvariante gemäß Fig. 6 angedeutet, ist es auch möglich, das aus mehreren Einzelelementen bestehende Kompensationselement 4 frei zu positionieren, beispielsweise außerhalb der Messelementauflagen 10 und 11, solange gewährleistet ist, dass am Ort des Messelementes 2 und am Ort des Kompensationselementes 4 gleiche Temperaturen $T_1$ und $T_2$ herrschen und sich somit in beiden Elementen 2 und 4 dasselbe Temperaturfeld bzw. der selbe Temperaturgradient einstellt.

Gemäß einer besonders vorteilhaften Ausführungsvariante ist das Messelement 2 und das Kompensationselement 4 in jeweils einem Teilbereich eines einzelnen piezoelektrischen Elementes 8 realisiert, wobei ein erster Teilbereich die Messelektroden 3 und ein zweiter Teilbereich die Kompensationselektroden 5 trägt. Wie in Fig. 7 dargestellt, befindet sich nur der Messbereich des Elementes 8 im Einflussbereich der Messelementauflagen 10, 11 und der Kompensationsbereich ragt darüber hinaus. Durch gleich großen Elektrodenflächen und entsprechend angeordnete, elektrische Verbindungsleitungen 7 erfolgt eine vollständige, innere Kompensation der Störgröße.

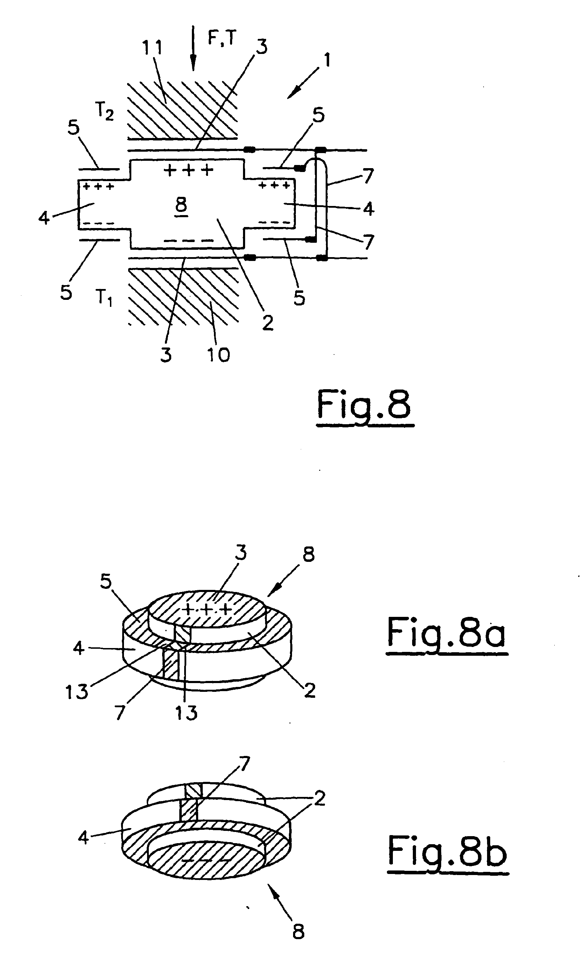

Bei der Verwendung eines einzelnen piezoelektrischen Elementes 8 mit innerer Kompensation können gemäß Fig. 8, Fig. 8a und Fig. 8b die beiden Teilbereiche als konzentrische Zylinder ausgeführt sein, wobei der das Messelement 2 realisierende Teilbereich eine größere Materialstärke aufweist als der das Kompensationselement 4 realisierende Teilbereich. Dadurch ist gewährleistet, dass die Messelementauflagen 10 und 11 nur auf den Messbereich wirken und auf einfache Weise mehrere für sich kompensierte Einzelelemente 8 zu einem Messelementstapel zusammengefasst werden können. Wie insbesondere aus den dreidimensionalen Ansichten Fig. 8a und Fig. 8b erkennbar, kann die elektrische Verbindung 7 der Messelektroden 3 mit den Kompensationselektroden 5 in vorteilhafter Weise durch eine direkt auf das piezoelektrische Element 8 aufgetragene elektrisch leitende Beschichtung erfolgen, welche zu der jeweils zu überbrückenden Elektrode eine elektrische Isolierung 13 aufweist.

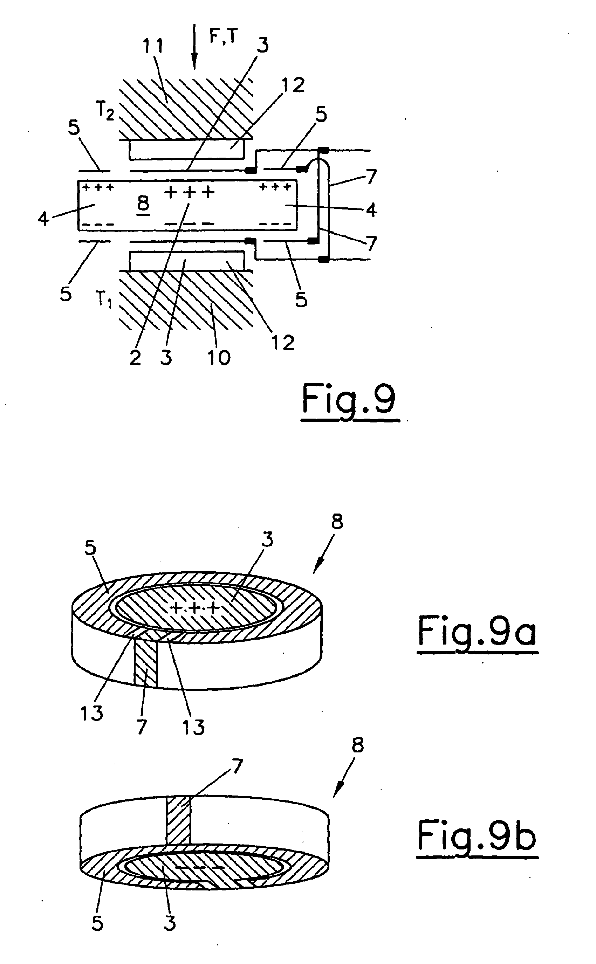

Beim Sensorelement gemäß Fig. 9, Fig. 9a und Fig. 9b sind die beiden Teilbereiche des Piezoelektrischen Elementes 8 ebenfalls als konzentrische Zylinder ausgeführt, wobei hier der das Messelement 2 realisierende Teilbereich und der das Kompensationselement 4 realisierende Teilbereich die gleiche Materialstärke aufweisen. Die fehlende Stufe in der Materialstärke wird hier durch ein leitendes Zwischenstück 12 oder durch entsprechend dickere Messelektroden 3 ersetzt.

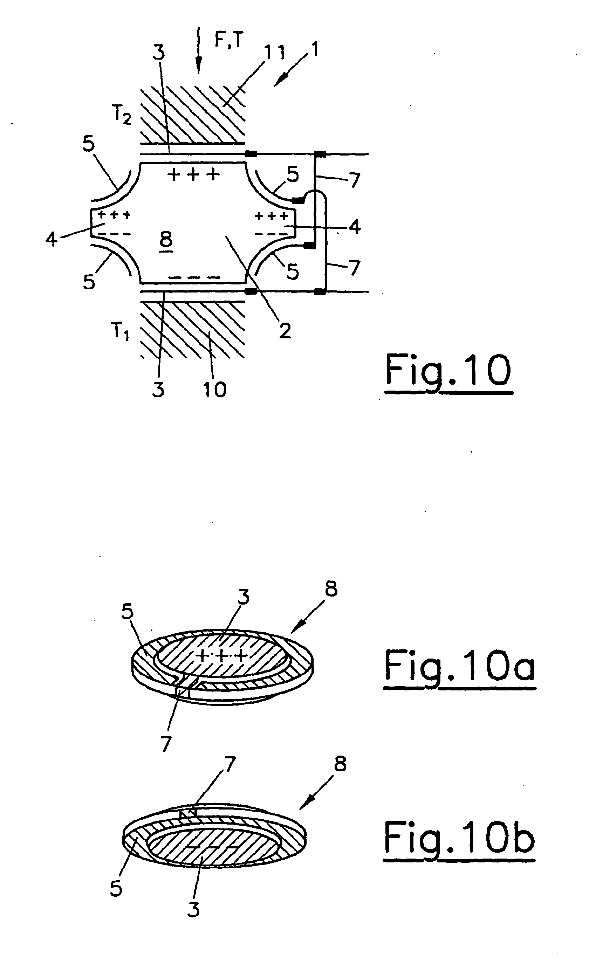

In der Ausführungsvariante gemäß Fig. 10, Fig. 10a und Fig. 10b erfolgt der Übergang von der kleineren Materialstärke des Kompensationselementes 4 zur größeren Materialstärke des Messelementes 2 in einer Kerbspannungen vermeidenden Form, sodass ein pillenförmiges Element 8 (siehe Fig. 10a, Fig. 10b) mit innerer Kompensation entsteht, welches auf einfache Weise gestapelt werden kann. Es ist auch möglich das Messelement 2 in einem äußeren Kreisring mit größerer Materialstärke zu realisieren und den kreisförmigen Innenbereich mit kleinerer Materialstärke als Kompensationselement 4 zu verwenden.

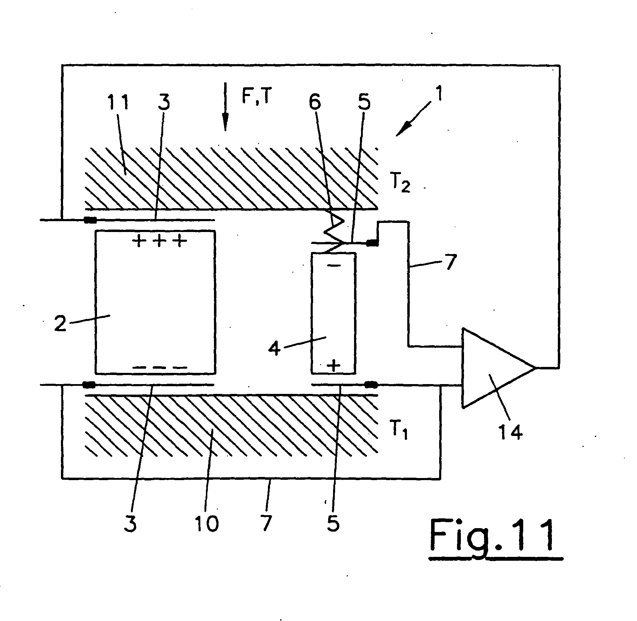

Die Ausführungsvariante gemäß Fig. 11 zeigt ein Sensorelement 1 mit einem Messelement 2 und einem Kompensationselement 4, welche voneinander abweichende Abmessungen aufweisen und aus unterschiedlichen Materialien hergestellt sein können. Zur Kompensation der Störgröße sind hier die Kompensationselektroden 5 unter Zwischenschaltung eines elektronischen Verstärkergliedes 14 mit den Messelektroden 3 verbunden.

Das Messelement und auch das Kompensationselement kann aus einer Vielzahl bekannter piezo- und pyroelektrischer Materialien bestehen. Nur als Beispiel seien hier Piezokeramiken oder konkret Turmalin, Lithiumniobat, Lithiumtantalat oder Polyvinylidenfluorid (PVDF) genannt.


**Patentansprüche**

1.  Sensorelement (1) mit
    zumindest einem Messelement (2), welches piezoelektrische und pyroelektrische Eigenschaften aufweist und mit Messelektroden (3) ausgestattet ist, wobei auf das zumindest eine Messelement (2) gleichzeitig eine Messgröße und eine Störgröße einwirkt und das von den Messelektroden (3) abgeleitete Messsignal ein Störsignal aufweist und zumindest einem Kompensationselement (4), welches piezoelektrische und/oder pyroelektrischen Eigenschaften aufweist und mit Kompensationselektroden (5) versehen ist, wobei auf das Kompensationselement (4) nur die Störgröße einwirkt, sodass vom Kompensationselement (4) ein Korrektursignal ableitbar ist, welches zur Kompensation des Störsignals im Messsignal dient,
    **dadurch gekennzeichnet,**
    **dass** das Kompensationselement (4) mit einer ersten (10) und einer zweiten Messelementauflage (11) des Messelementes (2) oder mit dem Messelement (2) entlang dessen Längserstreckung zwischen den Messelementauflagen (10, 11) in thermischem Kontakt steht, sodass sich im Messelement (2) und im Kompensationselement (4) im Wesentlichen dasselbe Temperaturfeld einstellt, wobei das Kompensationselement (4) zu zumindest einer der Messelementauflagen (10, 11) von der Einleitung mechanischer Größen entkoppelt ist.

2.  Sensorelement (1) nach Anspruch 1, **dadurch gekennzeichnet, dass** das Kompensationselement (4) zu zumindest einer Messelementauflage (10, 11) ein mechanische Kräfte absorbierendes, gut wärmeleitendes Element (6) aufweist.

3.  Sensorelement (1) nach Anspruch 1 oder 2, **dadurch gekennzeichnet, dass** die Kompensationselektroden (5) mit den Messelektroden (3) eine elektrisch leitende Verbindung (7) aufweisen und deren Flächen ein Verhältnis aufweisen, das der Kompensierung der Störgröße dient.

4.  Sensorelement (1) nach Anspruch 1 oder 2, **dadurch gekennzeichnet, dass** die Kompensationselektroden (5) unter Zwischenschaltung eines elektronischen Verstärkergliedes (14) mit den Messelektroden (3) verbunden sind.

5.  Sensorelement (1) nach einem der Ansprüche 1 bis 4, **dadurch gekennzeichnet, dass** das zumindest eine Messelement (2) und das zumindest eine Kompensationselement (4) aus dem selben Material bestehen.

6.  Sensorelement (1) nach einem der Ansprüche 1 bis 5, **dadurch gekennzeichnet, dass** die für die Messgröße und die Störgröße wirksamen Querschnitte des Messelementes (2) und des Kompensationselementes (4) gleich groß sind.

7. Sensorelement (1) nach einem der Ansprüche 1 bis 6, **dadurch gekennzeichnet, dass** die Messgröße eine veränderliche mechanische Größe (F), beispielsweise Kraft, Druck, Spannung oder Beschleunigung, und die Störgröße eine veränderliche Temperatur (T) ist.

8. Sensorelement (1) nach einem der Ansprüche 1 bis 7, **dadurch gekennzeichnet, dass** das Messelement (2) und das Kompensationselement (4) in einer parallelen oder antiparallelen Anordnung nebeneinander angeordnet sind.

9. Sensorelement (1) nach einem der Ansprüche 1 bis 7, **dadurch gekennzeichnet, dass** das Messelement (2) und das Kompensationselement (4) als konzentrische Zylinder angeordnet sind.

10. Sensorelement (1) nach einem der Ansprüche 1 bis 9, **dadurch gekennzeichnet, dass** das Messelement (2) und/ oder das Kompensationselement (4) unter Nutzung des longitudinalen oder des transversalen Piezoeffektes aus mehreren Einzelelementen bestehen.

11. Sensorelement (1) nach einem der Ansprüche 1 bis 9, **dadurch gekennzeichnet, dass** das Messelement (2) und das Kompensationselement (4) in zwei Teilbereichen eines einzelnen piezoelektrischen Elementes (8) realisiert sind, wobei ein erster Teilbereich die Messelektroden (3) und ein zweiter Teilbereich die Kompensationselektroden (5) trägt.

12. Sensorelement (1) nach Anspruch 11, **dadurch gekennzeichnet, dass** die beiden Teilbereiche als konzentrische Zylinder ausgeführt sind, wobei der das Messelement (2) realisierende Teilbereich eine größere Materialstärke aufweist als der das Kompensationselement (4) realisierende Teilbereich.

13. Sensorelement (1) nach Anspruch 12, **dadurch gekennzeichnet, dass** der Übergang von der kleineren Materialstärke des Kompensationselementes (4) zur größeren Materialstärke des Messelementes (2) in einer Kerbspannungen vermeidenden Form erfolgt.

14. Sensorelement (1) nach einem der Ansprüche 11 bis 13, **dadurch gekennzeichnet, dass** die elektrische Verbindung (7) der Messelektroden (3) mit den Kompensationselektroden (5) durch eine direkt auf das piezoelektrische Element (8) aufgetragene elektrisch leitende Beschichtung erfolgt.

**Claims**

1. Sensor element (1) with
at least one measuring element (2), which has piezoelectric and pyroelectric properties and is provided with measuring electrodes (3), where a measurement variable and a disturbance variable act simultaneously on the at least one measuring element (2), and where the measurement signal picked up by the measuring electrodes (3) contains a noise signal, and with
at least one compensating element (4), which has piezoelectric and/or pyroelectric properties and is provided with compensating electrodes (5), where only the disturbance variable acts on the compensating element (4), such that a correction signal is derivable from the compensating element (4), which is used to compensate the noise signal in the measurement signal,
**characterised in that**
the compensating element (4) is in thermal contact with a first (10) and a second measuring element support (11) of the measuring element (2), or with the measuring element (2) along its longitudinal extension between said measuring element supports (10, 11), such that essentially the same temperature field will prevail in the measuring element (2) and in the compensating element (4), with the compensating element (4) being decoupled concerning the input of mechanical quantities from at least one of the measuring element supports (10, 11).

2. Sensor element (1) according to claim 1, **characterised in that** the compensating element (4) is provided with an element (6) which absorbs mechanical forces and is a good heat conductor, against at least one of said measuring element supports (10, 11).

3. Sensor element (1) according to claim 1 or 2, **characterised in that** the compensating electrodes (5) are connected to the measuring electrodes (3) by means of electrically conductive leads (7), and that the ratio of the areas of the electrodes is such that the disturbance variable is compensated.

4. Sensor element (1) according to claim 1 or 2, **characterised in that** the compensating electrodes (5) are connected to the measuring electrodes (3) via an intermediate electronic amplifying device (14).

5. Sensor element (1) according to any of claims 1 to 4, **characterised in that** the at least one measuring element (2) and the at least one compensating element (4) are made of the same material.

6. Sensor element (1) according to any of claims 1 to 5, **characterised in that** the cross-sections of the measuring element (2) and the compensating element (4), which are effective for the measurement variable and the disturbance variable, are of equal size.

7. Sensor element (1) according to any of claims 1 to 6, **characterised in that** the measurement variable is a varying mechanical quantity (F), for instance force, pressure, stress, or acceleration, and that the disturbance variable is a varying temperature (T).

8. Sensor element (1) according to any of claims 1 to 7, **characterised in that** the measuring element (2) and the compensating element (4) are positioned side by side in a parallel or anti-parallel configuration.

9. Sensor element (1) according to any of claims 1 to 7, **characterised in that** the measuring element (2) and the compensating element (4) are configured as concentric cylinders.

10. Sensor element (1) according to any of claims 1 to 9, **characterised in that** the measuring element (2) and/or the compensating element (4) consist of a number of single elements making use of the longitudinal or the transversal piezoelectric effect.

11. Sensor element (1) according to any of claims 1 to 9, **characterised in that** the measuring element (2) and the compensating element (4) are realized in two partial regions of a single piezoelectric element (8), a first partial region carrying the measuring electrodes (3) and a second partial region the compensating electrodes (5).

12. Sensor element (1) according to claim 11, **characterised in that** the two partial regions are configured as concentric cylinders, the partial region forming the measuring element (2) having greater material thickness than the partial region forming the compensating element (4).

13. Sensor element (1) according to claim 12, **characterised in that** the transition from the lesser material thickness of the compensating element (4) to the greater material thickness of the measuring element (2) is in a form avoiding stress concentration.

14. Sensor element (1) according to any of claims 11 to 13, **characterised in that** the electrical connection (7) between the measuring electrodes (2) and the compensating electrodes (5) is implemented by an electrically conductive coating which is directly applied on the piezoelectric element (8).

**Revendications**

1. Elément capteur (1) comprenant :

   - au moins un élément de mesure (2) ayant des propriétés piézoélectriques et pyroélectriques et équipé d'électrodes de mesure (3),
   - au moins un élément de mesure (2) étant soumis simultanément à une grandeur de mesure et à une grandeur parasite, et le signal de mesure fourni par les électrodes de mesure (3) contient un signal parasite, et
   - au moins un élément de compensation (4) ayant des propriétés piézo-électriques et/ou pyroélectriques est muni d'électrodes de compensation (5),
   - l'élément de compensation (4) n'étant soumis qu'à l'action de la grandeur parasite de sorte qu'il génère un signal de correction servant à compenser le signal parasite contenu dans le signal de mesure,

   **caractérisé en ce que**

l'élément de compensation (4) est en contact thermique avec un premier appui d'élément de mesure (10) et un second appui d'élément de mesure (11) de l'élément de mesure (2) ou est en contact thermique avec l'élément de mesure (2) suivant son extension longitudinale entre les appuis d'élément de mesure (10, 11), de façon que pratiquement le même champ de températures se règle dans l'élément de mesure (2) et dans l'élément de compensation (4), et

l'élément de compensation (4) est découplé au moins de l'un des appuis d'élément de mesure (10, 11) avant d'appliquer les grandeurs mécaniques.

2. Elément capteur (1) selon la revendication 1,
**caractérisé en ce que**
l'élément de compensation (4) comporte, pour au moins un appui de l'élément de mesure (10, 11), un élément (6) bon conducteur de chaleur qui absorbe les efforts mécaniques.

3. Elément capteur (1) selon la revendication 1 ou 2,
**caractérisé en ce que**
les électrodes de compensation (5) ont une liaison électroconductrice (7) avec les électrodes de mesure (3), et leurs surfaces ont un rapport servant à compenser la grandeur parasite.

4. Elément capteur (1) selon la revendication 1 ou 2,
**caractérisé en ce que**
les électrodes de compensation (5) sont reliées aux électrodes de mesure (3) avec interposition d'un organe amplificateur électronique (14).

5. Elément capteur (1) selon les revendications 1 à 4,
**caractérisé en ce qu'**
au moins un élément de mesure (2) et au moins un élément de compensation (4) sont réalisés dans le même matériau.

6. Elément capteur (1) selon les revendications 1 à 5,
**caractérisé en ce que**
la section de l'élément de mesure (2) et celle de l'élément de compensation (4), efficace pour la grandeur de mesure et la grandeur parasite, ont les mêmes dimensions.

7. Elément capteur (1) selon les revendications 1 à 6,
**caractérisé en ce que**
la grandeur de mesure est une grandeur mécanique variable (F) telle qu'une force, une pression, une tension ou une accélération et la grandeur parasite est une température variable (T).

8. Elément capteur (1) selon les revendications 1 à 7,
**caractérisé en ce que**
l'élément de mesure (2) et l'élément de compensation (4) sont installés de façon juxtaposée selon une disposition parallèle ou antiparallèle.

9. Elément capteur (1) selon les revendications 1 à 7,
**caractérisé en ce que**
l'élément de mesure (2) et l'élément de compensation (4) sont des cylindres concentriques.

10. Elément capteur (1) selon les revendications 1 à 9,
**caractérisé en ce que**
l'élément de mesure (2) et/ou l'élément de compensation (4) sont formés de plusieurs éléments séparés utilisant l'effet piézo-électrique longitudinal ou transversal.

11. Elément capteur (1) selon les revendications 1 à 9,
**caractérisé en ce que**
l'élément de mesure (2) et l'élément de compensation (4) sont réalisés dans deux zones partielles d'un unique élément piézo-électrique (8), et une première zone partielle porte les électrodes de mesure (3) et une seconde zone partielle porte les électrodes de compensation (5).

12. Elément capteur (1) selon la revendication 11,

**caractérisé en ce que**
les deux zones partielles sont des cylindres concentriques et la zone partielle réalisant l'élément de mesure (2) a la même épaisseur de matière que la zone partielle réalisant l'élément de compensation (4).

**13.** Elément capteur (1) selon la revendication 12,
**caractérisé en ce que**
le passage entre la petite épaisseur de matière de l'élément de compensation (4), vers la grande épaisseur de matière de l'élément de mesure (2) se fait suivant une forme évitant les tensions de cisaillement.

**14.** Elément capteur (1) selon les revendications 11 à 13,
**caractérisé en ce que**
la liaison électrique (7) des électrodes de mesure (3) avec les électrodes de compensation (5) se fait par l'intermédiaire d'un revêtement électro-conducteur appliqué directement sur l'élément piézo-électrique (8).

EP 1 797 603 B1

Fig.1a        Fig.1b        Fig.1c

**Fig.2**

**Fig.3**

Fig.4

Fig.5

_Fig.6_

_Fig.7_

14

## Fig.8

## Fig.8a

## Fig.8b

Fig.9

Fig.9a

Fig.9b

16

Fig.10

Fig.10a

Fig.10b

11  3        F,T    6   5        1

T₂

+ + +

2

4        −

− − −        +        7

3        10   7   5        T₁

14

Fig.11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0055345 A1
- US 3877308 A